# EUROPEAN PATENT SPECIFICATION

(11) **EP 3 680 711 B1**
(45) Date of publication and mention of the grant of the patent: **06.12.2023**
(21) Application number: 18854723.6
(22) Date of filing: 15.08.2018
(51) Int. Cl.: G02F 1/1337, G02F 1/1362

(54) **ARRAY SUBSTRATE, LIQUID CRYSTAL DISPLAY PANEL AND DISPLAY DEVICE**
ARRAYSUBSTRAT, FLÜSSIGKRISTALLTAFEL UND ANZEIGEVORRICHTUNG
SUBSTRAT DE MATRICE, PANNEAU D'AFFICHAGE À CRISTAUX LIQUIDES ET DISPOSITIF D'AFFICHAGE

(30) Priority: 05.09.2017 CN 201710790394
(43) Date of publication of application: 15.07.2020
(73) Proprietor: BOE Technology Group Co., Ltd., Beijing 100015 (CN)
(72) Inventor: MA, Yongda, Beijing 100176 (CN); WU, Xinyin, Beijing 100176 (CN); QIAO, Yong, Beijing 100176 (CN)
(74) Representative: Cohausz & Florack
(86) International application number: PCT/CN2018/100653
(87) International publication number: WO 2019/047695

(56) References cited:
- WO-A1-2009/060657
- CN-A- 101 042 502
- CN-A- 101 799 597
- CN-A- 105 355 630
- CN-A- 107 390 443
- JP-A- 2000 039 632
- KR-A- 20040 001 972
- KR-A- 20100 059 052
- US-A1- 2001 004 274
- US-A1- 2005 122 459
- US-A1- 2012 062 814

## Description

This application claims the benefit of Chinese Patent Application No. 201710790394.9, filed with the Chinese Patent Office on September 05, 2017, and entitled "A display panel and a display device".

### Field

This disclosure relates to the field of display technologies, and particularly to an array substrate, a liquid crystal display panel, and a display device.

### Background

A Liquid Crystal Display (LCD) has been widely applied to various fields due to its light weight, low drive voltage, low power consumption, and other advantages. As the market of liquid crystal displays is growing constantly, a number of display modes have emerged, e.g., the Twisted Nematic (TN) mode, the In-Plane Switching (IPS) mode, etc. At present, there is a growing demand of users for a liquid crystal display with a high quality, and particularly a liquid crystal display with a large screen and a wide angle of view.

US patent application US 2001/004274A1 relates to a VA (Vertical Aligned) type active-matrix liquid crystal display capable of stabilizing a boundary position between divided areas (alignment areas). The liquid crystal display comprises a TFT (thin film transistor) substrate including a pixel electrode provided for each pixel and a driving element such as a TFT provided for each pixel electrode, an opposite substrate disposed opposite to the TFT substrate and including an opposite electrode, and a liquid crystal layer sandwiched between the TFT substrate and the opposite substrate. Each pixel electrode has a recess in groove shape formed therein. The pixel electrode preferably has a generally rectangular shape. The recess is provided such that it extends from one of a pair of opposite sides of the pixel electrode to the other to divide the pixel electrode into two parts.
International patent application WO 2009/060657 A1 relates to a transflective liquid crystal display having an improved reflectance and a voltage-reflection brightness characteristic hardly causing gray-scale inversion. The transflective liquid crystal display comprises a pair of substrates (50, 60) and a liquid crystal layer (70) sandwiched between the pair of substrates. The liquid crystal display further comprises a transmissive region (T) and a reflective region (R). In the reflective region (R), a projection (22) for controlling the orientation of the liquid crystal in the liquid crystal layer is provided. Colored layers (24) are provided in the transmissive region (T) and the reflective region (R) of at Q least one of the substrates (50, 60). An area of each of the colored layers (24) where the projections (22) are provided has a portion whose thickness is smaller than that of the other portion or an opening (24a).
US patent application US 2005/0122459A1 discloses that a liquid crystal display is provided, which includes: a first substrate; a first signal line formed on the first substrate; a second signal line formed on the first substrate and intersecting the first signal line; a thin film transistor connected to the first and the second signal lines; a pixel electrode connected to the thin film transistor; a second substrate; a common electrode formed on the second substrate; a liquid crystal layer interposed between the first substrate and the second substrate; and a tilt direction determining member formed on one of the first and the second substrates and having a notch.

### Summary

The embodiments of the disclosure provide an array substrate including: a base substrate; a plurality of pixel units on the base substrate; at least one recess in the plurality of pixel units; and pixel electrodes in the plurality of pixel units and covering the at least one recess; where an orthographic projection of an opening of each recess onto the base substrate covers an orthographic projection of a bottom of the recess onto the base substrate, and an area of the orthographic projection of the opening of the recess onto the base substrate is greater than an area of the orthographic projection of the bottom of the recess onto the base substrate; where the array substrate further includes: a reservation layer between the pixel electrodes and the base substrate, and a first insulation layer between the reservation layer and the pixel electrodes; where the first insulation layer includes at least one first via hole in the plurality of pixel units, and the reservation layer includes a second via hole corresponding to each first via hole; and an orthographic projection of each first via hole onto the base substrate, and an orthographic projection of a corresponding second via hole onto the base substrate have an overlapping area; where the array substrate further includes a plurality of data lines; a plurality of gate lines; thin film transistors in respective pixel units; a gate insulation layer between the active layers of the thin film transistors and a layer at which gates of the thin film transistors are located; a second insulation layer between a layer where sources and drains of the thin film transistors are located and active layers of the thin film transistors; where the gate insulation layer includes a third via hole corresponding to each first via hole; the orthographic projection of each first via hole onto the base substrate, and an orthographic projection of a corresponding third via hole onto the base substrate have an overlapping area; and each recess includes a first via hole, a corresponding second via hole, and a corresponding third via hole; where the reservation layer is arranged at a same layer, and made of a same material, as the plurality of data lines; or the reservation layer is arranged at a same layer, and made of a same material, as the plurality of gate lines; or the reservation layer is arranged at a same layer, and made of a same material, as active layers of the thin film transistors; or the reservation layer includes a first sub-reservation layer and a second sub-reservation layer; where the first sub-reservation layer is arranged at a same layer as the sources of the thin film transistors, and the second sub-reservation layer is arranged at a same layer as the active layers of the thin film transistors.

Optionally, in the embodiments of the disclosure, a pattern of each first via hole includes an ellipse, a pattern of each second via hole includes an ellipse, and an orthographic projection of a long axis of each second via hole onto the base substrate intersects with an orthographic projection of a long axis of a corresponding first via hole onto the base substrate.

Optionally, in the embodiments of the disclosure, an angle between the orthographic projection of the long axis of each second via hole onto the base substrate, and the orthographic projection of the long axis of the corresponding first via hole onto the base substrate is greater than 0 degree, and less than or equal to 90 degrees.

Optionally, in the embodiments of the disclosure, the angle between the orthographic projection of the long axis of each second via hole onto the base substrate, and the orthographic projection of the long axis of the corresponding first via hole onto the base substrate is equal to or greater than 35 degrees, and less than or equal to 75 degrees.

Optionally, in the embodiments of the disclosure, the array substrate further includes: an auxiliary layer between the gate insulation layer and the base substrate; the auxiliary layer includes a fourth via hole corresponding to each second via hole; and an orthographic projection of each second via hole onto the base substrate covers and is larger than an orthographic projection of a corresponding fourth via hole onto the base substrate; and each recess includes a first via hole, a corresponding second via hole, and a corresponding fourth via hole.

Optionally, in the embodiments of the disclosure, each fourth via hole includes a tapered hole, and an angle between an inclined surface of the tapered hole; and an upper surface of the base substrate is greater than or equal to 15 degrees, and less than or equal to 75 degrees.

Optionally, in the embodiments of the disclosure, the array substrate further includes a plurality of gate lines; and the auxiliary layer is located at the same layer as, and arranged insulated from, the plurality of gate lines.

Optionally, in the embodiments of the disclosure, the array substrate further includes a common electrode arranged at the same layer as the plurality of gate lines.

Optionally, in the embodiments of the disclosure, an orthographic projection of a long axis of a second via hole arranged on the first sub-reservation layer onto the base substrate intersects with an orthographic projection of a long axis of a corresponding second via hole arranged on the second sub-reservation layer onto the base substrate; where the second via hole arranged on the first sub-reservation layer and the corresponding second via hole arranged on the second sub-reservation layer have an elliptical shape.

Optionally, in the embodiments of the disclosure, an orthographic projection of a center of the second via hole arranged on the first sub-reservation layer onto the base substrate overlaps with an orthographic projection of a center of the corresponding second via hole arranged on the second sub-reservation layer onto the base substrate.

Optionally, in the embodiments of the disclosure, an angle between the orthographic projection of the long axis of the second via hole arranged on the first sub-reservation layer onto the base substrate, and the orthographic projection of the long axis of the corresponding second via hole arranged on the second sub-reservation layer onto the base substrate is greater than 0 degree, and less than or equal to 90 degrees.

Optionally, in the embodiments of the disclosure, the angle between the orthographic projection of the long axis of the second via hole arranged on the first sub-reservation layer onto the base substrate, and the orthographic projection of the long axis of the corresponding second via hole arranged on the second sub-reservation layer onto the base substrate is equal to or greater than 35 degrees, and less than or equal to 75 degrees.

Optionally, in the embodiments of the disclosure, each recess is arranged on an upper surface of the base substrate; and a thickness of the base substrate in an area where the recess is located is less than a thickness of the base substrate in the other areas.

Correspondingly, the embodiments of the disclosure further provide a liquid crystal display panel including the array substrate according to the embodiments of the disclosure.

Correspondingly, the embodiments of the disclosure further provide a display device including the liquid crystal display panel according to the embodiments of the disclosure.

### Brief Description of the Drawings

Fig. 1 is a first schematic structural diagram of an array substrate according to the embodiments of the disclosure in a top view.
Fig. 2 is a first schematic structural diagram of the array substrate according to the embodiments of the disclosure in a partially sectional view.
Fig. 3 is a schematic structural diagram of a first via hole and a second via hole according to the embodiments of the disclosure.
Fig. 4 is a second schematic structural diagram of the array substrate according to the embodiments of the disclosure in a top view.
Fig. 5 is a second schematic structural diagram of the array substrate according to the embodiments of the disclosure in a partially sectional view.
Fig. 6 is a third schematic structural diagram of the array substrate according to the embodiments of the disclosure in a partially sectional view.
Fig. 7 is a fourth schematic structural diagram of the array substrate according to the embodiments of the disclosure in a partially sectional view.
Fig. 8 is a fifth schematic structural diagram of the array substrate according to the embodiments of the disclosure in a partially sectional view.

### Detailed Description of the Embodiments

The technical solutions according to the embodiments of the invention will be described below clearly and fully with reference to the drawings. The scope of the invention is defined by the appended claims.

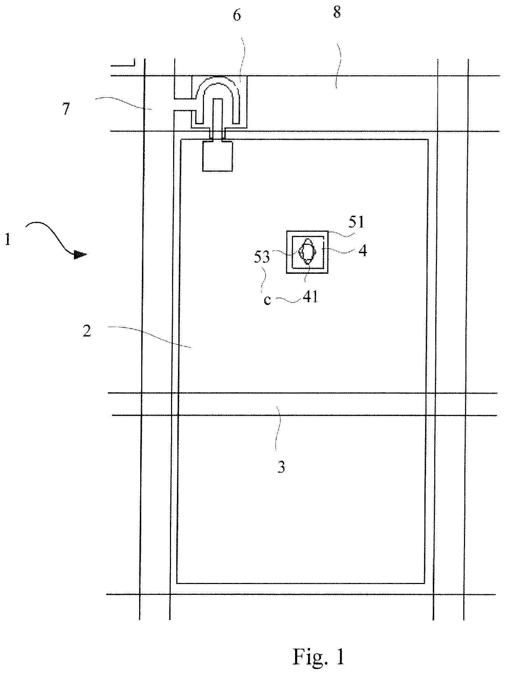

As illustrated in Fig. 1, Fig. 2, and Fig. 3, an array substrate according to the embodiments of the disclosure includes: a base substrate 101; a plurality of pixel units 1 on the base substrate 101; at least one recess c in the plurality of pixel units 1, and pixel electrodes 2 in the plurality of pixel units 1 and covering the at least one recess c; where an orthographic projection of an opening of each recess c onto the base substrate 101 covers an orthographic projection of a bottom of the recess c onto the base substrate 101, and an area of the orthographic projection of the opening of the recess c onto the base substrate 101 is greater than an area of the orthographic projection of the bottom of the recess c onto the base substrate 101.

In the array substrate according to the embodiments of the disclosure, the recess(s) is or are arranged in the pixel units, the orthographic projection of the opening of each recess onto the base substrate covers the orthographic projection of the bottom thereof onto the base substrate, and the area of the orthographic projection of the opening of each recess onto the base substrate is greater than the area of the orthographic projection of the bottom thereof onto the base substrate; and pixel electrodes cover the recess(s) so that the pixel electrodes can be formed with recess area(s) and circumferential depth difference(s) exists or exist in the recess area(s) of the pixel electrodes. Furthermore, when the array substrate is applied to a liquid crystal display panel, electric field(s) around the recess area(s) of the pixel electrodes can vary along a circumferential direction. Stated otherwise, since the pixel electrodes are provided with recess area(s), an electric field between the pixel electrodes and a common electrode can vary so that liquid crystal molecules are arranged in a direction of the electric field to form a multi-domain state, and thus a multi-domain liquid crystal display can be achieved. Furthermore, the liquid crystal display panel according to the embodiments of the disclosure can have an extended angle of view, and thus the display effect of the image can be improved.

In a particular implementation, in the embodiments of the disclosure, as illustrated in Fig. 1, Fig. 2, and Fig. 3, the array substrate further includes: a reservation layer 4 between the pixel electrodes 2 and the base substrate 101, and a first insulation layer 51 between the reservation layer 4 and the pixel electrodes 2, where the first insulation layer 51 includes at least one first via hole 53 in the pixel units 1, and the reservation layer 4 includes a second via hole 41 corresponding to each first via hole 53; where an orthographic projection of each first via hole 53 onto the base substrate 101, and an orthographic projection of a corresponding second via hole 41 onto the base substrate 101 have an overlapping area; and each recess c can include a first via hole 53 and a corresponding second via hole 41. In this way, an orthographic projection of each second via hole 41 onto the base substrate 101 partially overlaps with an orthographic projection of a corresponding first via hole 53 onto the base substrate 101, and the orthographic projection of each first via hole 53 onto the reservation layer 4 covers at least an area of the reservation layer 4 in which no second via hole 41 is arranged, so that there is a depth difference in a circumferential direction of each recess c, and thus there is a depth difference in a circumferential direction of a recess area of the pixel electrodes. Furthermore, since the pixel electrodes come into contact with the reservation layer, thereby the adhesiveness of the pixel electrodes can be improved.

In a particular implementation, in the embodiments of the disclosure, as illustrated in Fig. 1, Fig. 2, and Fig. 3, a pattern of each second via hole 41 includes an ellipse, and a pattern of each first via hole 51 can also include an ellipse. An orthographic projection of a long axis of each second via hole 41 onto the base substrate 101 intersects with an orthographic projection of a long axis of a corresponding first via hole 53 onto the base substrate 101, thus resulting in a recess with a different circumferential depth. Furthermore, an angle a between the orthographic projection of the long axis of each second via hole 41 onto the base substrate 101, and the orthographic projection of the long axis of the corresponding first via hole 53 onto the base substrate 101 can be one of a number of angles, and optionally the angle a is greater than 0 degree, and less than or equal to 90 degrees, e.g., 15 degrees, 20 degrees, 25 degrees, 30 degrees, 34 degrees, 40 degrees, 55 degrees, 59 degrees, 70 degrees, 78 degrees, 83 degrees, 88 degrees, 90 degrees, etc., although a repeated description thereof will be omitted here. Furthermore, in the embodiments of the disclosure, the angle a between the orthographic projection of the long axis of each second via hole 41 onto the base substrate 101, and the orthographic projection of the long axis of the corresponding first via hole 53 onto the base substrate 101 is equal to or greater than 35 degrees, and less than or equal to 75 degrees. In this angle range, it is easier to realize a multi-domain liquid crystal display. Of course, the pattern of each first via hole can alternatively include a circle, and a diameter thereof can be greater than that of a minor axis of a corresponding second via hole.

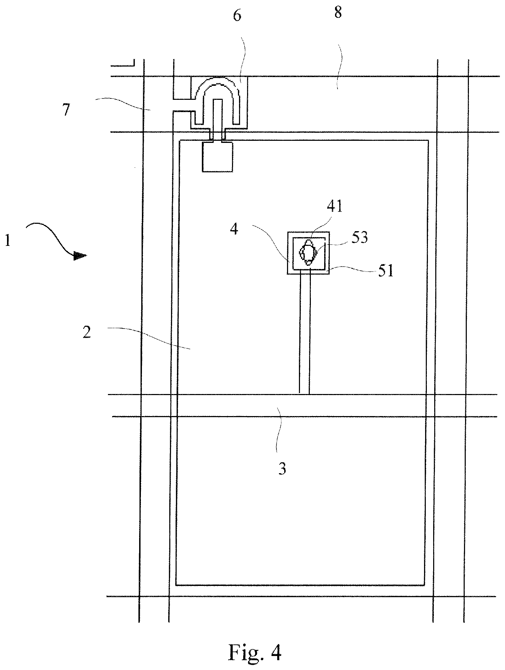

In a particular implementation, as illustrated in Fig. 1 and Fig. 4, the array substrate further includes: a plurality of data lines 7 extending in a column direction, a plurality of gate lines 8 extending in a row direction, and thin film transistors located in respective pixel units; where each thin film transistor includes a gate, an active layer 6, and a source and a drain electrically connected with the active layer, which are located on the base substrate in that order. And the array substrate further includes: a gate insulation layer between active layers and a layer at which gates are located, a second insulation layer between the active layers and a layer at which sources and drains are located, a third insulation layer between the layer at which the sources and the drains are located and a layer at which the pixel electrodes are located. The sources and the drains are electrically connected with the active layers through via holes extending through the second insulation layer. The pixel electrodes are electrically connected with the drains of the thin film transistors through via holes extending through the third insulation layer. The gates of the thin film transistors are connected with the gate lines, the sources are connected with the data lines, and the drains are connected with the pixel electrodes. Furthermore, the data lines can be arranged at the same layer, and made of the same material, as the sources and the drains of the thin film transistors. The gate lines can be arranged at the same layer, and made of the same material, as the gates of the thin film transistors. In this way, the data lines can be located between the base substrate and the first insulation layer.

Furthermore, as illustrated in Fig. 1 and Fig. 4, the array substrate further includes a common electrode 3. In a practical application, the shapes of the pixel electrodes and the common electrode can be set as needed in reality, and there may be a number of particular positions of the common electrode 3. Optionally, in a particular implementation, the array substrate further includes a common electrode arranged at the same layer as the gate lines. In this way, the liquid crystal molecules can be driven by an electric field between the common electrode and the pixel electrodes for an effect of forming the multi-domain liquid crystal. This structural arrangement can simplify a fabrication process, and make it convenient to fabricate the array substrate.

In a particular implementation, the reservation layer 4 can be arranged at the same layer, and made of the same material, as the data lines 7. In this way, the patterns of the reservation layer and the data lines can be formed in one patterning process to thereby simplify a fabrication process, save a production cost, and improve the production efficiency. At this time, the third insulation layer can be used as the first insulation layer. The reservation layer may not be electrically connected with any of the data lines, the sources and the drains, or the reservation layer may be electrically connected with the drains, although the embodiments of the disclosure will not be limited thereto.

Alternatively, the reservation layer can be arranged at the same layer, and made of the same material, as the gate lines. In this way, the patterns of the reservation layer and the gate lines can be formed in one patterning process to thereby simplify a fabrication process, save a production cost, and improve the production efficiency. At this time, the second insulation layer and the third insulation layer can be used as the first insulation layer.

Alternatively, the reservation layer can be arranged at the same layer, and made of the same material, as the active layers of the thin film transistors. In this way, the patterns of the reservation layer and the active layers can be formed in one patterning process to thereby simplify a fabrication process, save a production cost, and improve the production efficiency. At this time, the second insulation layer and the third insulation layer can be used as the first insulation layer.

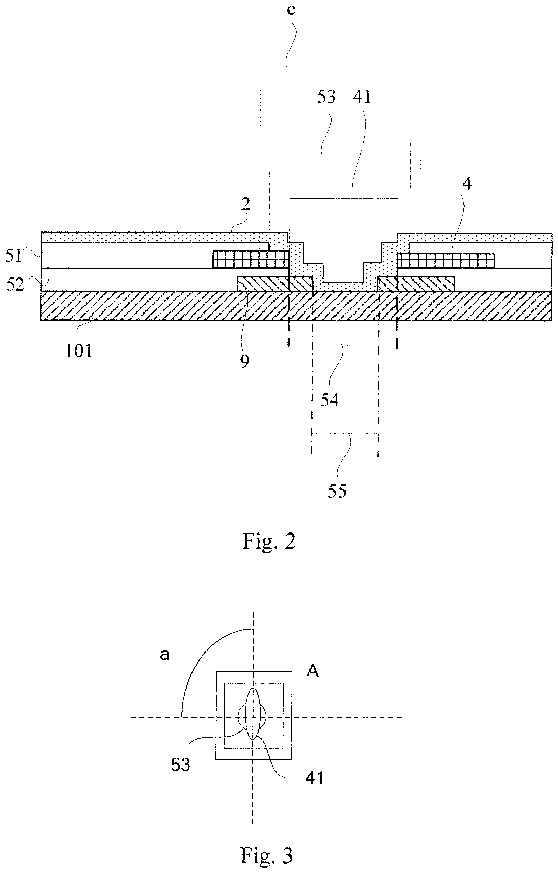

According to the claimed invention, as illustrated in Fig. 2, the gate insulation layer 52 includes a third via hole 54 corresponding to each first via hole 53; the orthographic projection of each first via hole 53 onto the base substrate 101, and an orthographic projection of a corresponding third via hole 54 onto the base substrate 101 have an overlapping area; and each recess c includes a first via hole 53, a corresponding second via hole 41, and a corresponding third via hole 54. In this way, a gradient of each recess c can be increased to thereby further increase the depth thereof.

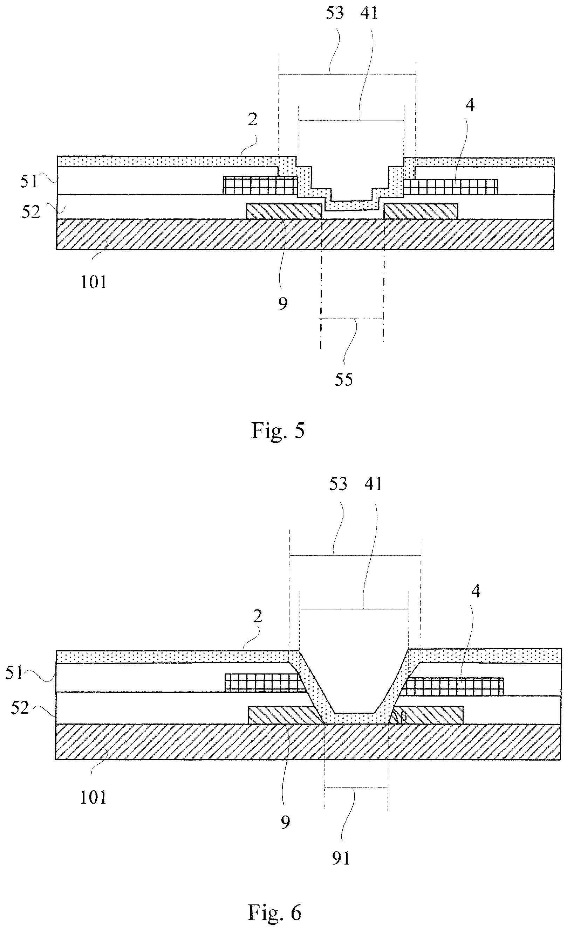

Furthermore, as illustrated in Fig. 2 and Fig. 5, the array substrate further includes: an auxiliary layer 9 between the gate insulation layer 52 and the base substrate 101; the auxiliary layer 9 includes a fourth via hole 55 corresponding to each second via hole 41; the orthographic projection of each second via hole 41 onto the base substrate 101 covers an orthographic projection of a corresponding fourth via hole 55 onto the base substrate 101; and each recess c can include a first via hole 53, a corresponding second via hole 41, and a corresponding fourth via hole 55. Furthermore, the orthographic projection of each second via hole 41 onto the base substrate 101 is larger than the orthographic projection of the corresponding fourth via hole 55 onto the base substrate 101 so that there are more steps of each recess c to thereby form the multi-domain liquid crystal further. In this way, the pixel electrodes can be further connected with the auxiliary layer 9 through the first via holes 53, the second via holes 41, and the fourth via holes 55 to thereby further improve the adhesiveness of the pixel electrode.

Furthermore, as illustrated in Fig. 6, each fourth via hole includes a tapered hole 91, where an angle β between an inclined surface of the tapered hole 91, and an upper surface of the base substrate 101 is greater than or equal to 15 degrees, and less than or equal to 75 degrees. In this way, the effect of the multi-domain display can be improved. Where the angle β above can be 15 degrees, 25 degrees, 30 degrees, 35 degrees, 40 degrees, 45 degrees, 60 degrees, 70 degrees, 75 degrees, etc., although a repeated description thereof will be omitted here. Furthermore, in order to facilitate fabrication, each first via hole 53, each second via hole 41, and each third via hole 54 can also be tapered holes.

Furthermore, in a particular implementation, the auxiliary layer can be located at the same layer as, and arranged insulated from, the gate lines. The auxiliary layer may or may not be made of the same material as the gate lines, although the embodiments of the disclosure will not be limited thereto. Furthermore, as illustrated in Fig. 1 and Fig. 2, the auxiliary layer 9 can be arranged insulated from the gate lines and the common electrode so that the gate insulation layer 52 can include the third via holes 54. As illustrated in Fig. 4 and Fig. 5, the auxiliary layer 9 can be arranged insulated from the gate lines, and the auxiliary layer 9 can be electrically connected with the common electrode, so that the gate insulation layer 52 will not include the third via holes 54 to thereby avoid the pixel electrodes 2 from being electrically connected with the common electrode 3.

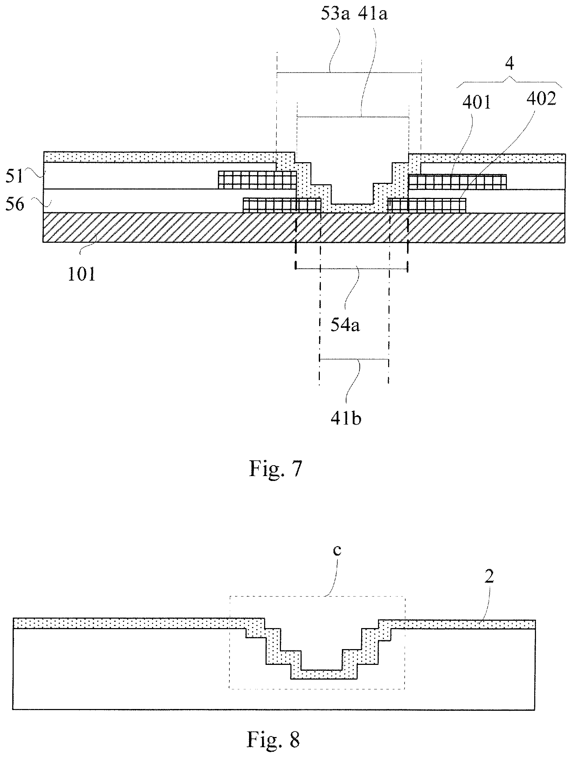

Furthermore, as illustrated in Fig. 7, the reservation layer 4 includes: a first sub-reservation layer 401 and a second sub-reservation layer 402, where the first sub-reservation layer 401 is arranged at the same layer as the sources of the thin film transistors, and the second sub-reservation layer 402 is arranged at the same layer as the active layers of the thin film transistors. Furthermore, each first via hole includes: a first sub-via hole 53a extending through the first insulation layer, and a second sub-via hole 54a extending through the second insulation layer 56. The first sub-reservation layer 401 includes a second via hole 41a, and the second sub-reservation layer 402 includes a second via hole 41b. In this way, the number of steps of each recess can be increased to thereby further increase the depth difference of the recess so as to improve the effect of the multi-domain display.

Furthermore, the patterns of each second via hole 41a and each second via hole 41b can include ellipses. An orthographic projection of a long axis of each second via hole 41a arranged on the first sub-reservation layer 401 onto the base substrate 101 intersects with an orthographic projection of a long axis of a corresponding second via hole 41b arranged on the second sub-reservation layer 402 onto the base substrate 101. In this way, there will be more steps of each recess to thereby make an electric field around each recess area of the pixel electrode more variable so as to further improve the effect of the multi-domain display.

Furthermore, the angle between the orthographic projection of the long axis of each second via hole 41a arranged on the first sub-reservation layer 401 onto the base substrate 101, and the orthographic projection of the long axis of the corresponding second via hole 41b arranged on the second sub-reservation layer onto the base substrate 101 is greater than 0 degree, and less than or equal to 90 degrees, e.g., 15 degrees, 20 degrees, 25 degrees, 30 degrees, 34 degrees, 40 degrees, 55 degrees, 59 degrees, 70 degrees, 78 degrees, 83 degrees, 88 degrees, 90 degrees, etc., although a repeated description thereof will be omitted here. Optionally, the angle between the orthographic projection of the long axis of each second via hole 41a onto the base substrate 101, and the orthographic projection of the long axis of the corresponding second via hole 41b onto the base substrate 101 is greater than or equal to 35 degrees, and less than or equal to 75 degrees.

Furthermore, in order to facilitate fabrication, and to improve the effect of the multi-domain display, an orthographic projection of a center of a second via hole arranged on the first sub-reservation layer onto the base substrate overlaps with an orthographic projection of a center of a corresponding second via hole arranged on the second sub-reservation layer onto the base substrate so that the orthographic projections of centers of a first via hole and a second via hole onto the base substrate 101 in a same recess can overlap with each other.

In a particular implementation, as illustrated in Fig. 8, each recess c is arranged on the upper surface of the base substrate 101, where a thickness of the base substrate 101 in an area where the recess c is located is less than a thickness of the base substrate 101 in the other areas. In this way, after the other layers are arranged on the base substrate, the other layers will be formed with a recess area, and a pixel electrode 2 can further cover the recess c so that the pixel electrode 2 can be formed with a recess area to thereby realize a multi-domain display.

Based upon the same inventive idea, the embodiments of the disclosure further provide a liquid crystal display panel including the array substrate according to the embodiments of the disclosure. The liquid crystal display panel addresses the problem under a similar principle to the array substrate above, so reference can be made to the implementation of the array substrate above for an implementation of the liquid crystal display panel, and a repeated description thereof will be omitted here.

Furthermore, in the embodiments of the disclosure, the liquid crystal display panel can further include: an opposite substrate arranged opposite to the array substrate, and a liquid crystal layer encapsulated between the array substrate and the opposite substrate.

Based upon the same inventive idea, the embodiments of the disclosure further provide a display device including the liquid crystal display panel according to the embodiments of the disclosure. Since the liquid crystal display panel can have an extended angle of view, and thus an improved image display effect, the display device according to the embodiments of the disclosure has a better display effect.

In a particular implementation, the display device according to the embodiments of the disclosure can be a mobile phone, a tablet computer, a TV set, a monitor, a notebook computer, a digital photo frame, a navigator, or any other product or component with a display function. All the other components indispensable to the display device shall readily occur to those ordinarily skilled in the art, so a repeated description thereof will be omitted here, and the embodiments of the disclosure will not be limited thereto.

Evidently those skilled in the art can make various modifications and variations to the invention. Thus the invention is also intended to encompass these modifications and variations thereto so long as the modifications and variations come into the scope of the claims appended to the invention.

## Claims

1. An array substrate, comprising:
a base substrate (101);
a plurality of pixel units (1) on the base substrate (101);
at least one recess (c) in the plurality of pixel units (1); and
pixel electrodes (2) in the plurality of pixel units (1) and covering the at least one recess (c);
wherein an orthographic projection of an opening of each recess (c) onto the base substrate (101) covers an orthographic projection of a bottom of the recess (c) onto the base substrate (101), and an area of the orthographic projection of the opening of the recess (c) onto the base substrate (101) is greater than an area of the orthographic projection of the bottom of the recess (c) onto the base substrate (101);
wherein the array substrate further comprises: a reservation layer (4) between the pixel electrodes (2) and the base substrate (101), and a first insulation layer (51) between the reservation layer (4) and the pixel electrodes (2); and
the first insulation layer (51) comprises at least one first via hole (53) in the plurality of pixel units (1);
wherein the reservation the layer (4) comprises at least one second via hole (41) corresponding to each first via hole (53); and
an orthographic projection of each first via hole (53) onto the base substrate (101), and an orthographic projection of a corresponding second via hole (41) onto the base substrate (101) have an overlapping area;
wherein the array substrate further comprises: a plurality of data lines (7); a plurality of gate lines (8); thin film transistors in respective pixel units (1); a gate insulation layer (52) between the active layers (6) of the thin film transistors, and a layer at which gates of the thin film transistors are located; a second insulation layer (56) between a layer where sources and drains of the thin film transistors are located and active layers (6) of the thin film transistors;
wherein the gate insulation layer (52) comprises at least one third via hole (54) corresponding to each first via hole (53);
the orthographic projection of each first via hole (53) onto the base substrate (101), and an orthographic projection of a corresponding third via hole (54) onto the base substrate (101) have an overlapping area; and
each recess (c) comprises a first via hole (53) from said at least one first via hole, a corresponding second via hole (41) from said at least one second via hole and a corresponding third via hole (54) from said at least one third via hole;
wherein the reservation layer (4) is arranged at a same layer, and made of a same material, as the plurality of data lines (7); or
the reservation layer (4) is arranged at a same layer, and made of a same material, as the plurality of gate lines (8); or
the reservation layer (4) is arranged at a same layer, and made of a same material, as active layers (6) of the thin film transistors; or
the reservation layer (4) comprises a first sub-reservation layer (401) and a second sub-reservation layer (402); wherein the first sub-reservation layer (401) is arranged at a same layer as the sources of the thin film transistors, and the second sub-reservation layer (402) is arranged at a same layer as the active layers (6) of the thin film transistors.

2. The array substrate according to claim 1, wherein a pattern of each first via hole (53) includes an ellipse, a pattern of each second via hole (41) comprises an ellipse; and an orthographic projection of a long axis of each second via hole (41) onto the base substrate (101) intersects with an orthographic projection of a long axis of a corresponding first via hole (53) onto the base substrate (101).

3. The array substrate according to claim 2, wherein an angle between the orthographic projection of the long axis of each second via hole (41) onto the base substrate (101), and the orthographic projection of the long axis of the corresponding first via hole (53) onto the base substrate (101) is greater than 0 degree, and less than or equal to 90 degrees.

4. The array substrate according to claim 1, wherein the array substrate further comprises: an auxiliary layer (9) between the gate insulation layer (52) and the base substrate (101); the auxiliary layer (9) comprises a fourth via hole (55) corresponding to each second via hole (41); and an orthographic projection of each second via hole (41) onto the base substrate (101) covers and is larger than an orthographic projection of a corresponding fourth via hole (55) onto the base substrate (101); and
each recess (c) comprises a first via hole (53), a corresponding second via hole (41), and a corresponding fourth via hole (55).

5. The array substrate according to claim 4, wherein each fourth via hole (55) comprises a tapered hole; and an angle between an inclined surface of the tapered hole, and an upper surface of the base substrate (101) is greater than or equal to 15 degrees, and less than or equal to 75 degrees.

6. The array substrate according to claim 4, wherein the array substrate further comprises a plurality of gate lines (8); and
the auxiliary layer (9) is located at a same layer as, and arranged insulated from, the plurality of gate lines (8);
wherein the array substrate further comprises a common electrode (3) arranged at a same layer as the plurality of gate lines (8).

7. The array substrate according to claim 1, wherein an orthographic projection of a long axis of a second via hole (41a) arranged on the first sub-reservation layer (401) onto the base substrate (101) intersects with an orthographic projection of a long axis of a corresponding second via hole (41b) arranged on the second sub-reservation layer (402) onto the base substrate (101); wherein the second via hole (41a) arranged on the first sub-reservation layer (401) and the corresponding second via hole (41b) arranged on the second sub-reservation layer (402) have an elliptical shape.

8. The array substrate according to claim 7, wherein an orthographic projection of a center of the second via hole (41a) arranged on the first sub-reservation layer (401) onto the base substrate (101) overlaps with an orthographic projection of a center of the corresponding second via hole (41b) arranged on the second sub-reservation layer (402) onto the base substrate (101); and
wherein an angle between the orthographic projection of the long axis of the second via hole (41a) arranged on the first sub-reservation layer (401) onto the base substrate (101), and the orthographic projection of the long axis of the corresponding second via hole (41b) arranged on the second sub-reservation layer (402) onto the base substrate (101) is greater than 0 degree, and less than or equal to 90 degrees.

9. A liquid crystal display panel, comprising the array substrate according to any one of claims 1 to 8.

10. A display device, comprising the liquid crystal display panel according to claim 9.

## Patentansprüche

1. Arraysubstrat, aufweisend:
ein Basissubstrat (101);
mehrere Pixeleinheiten (1) auf dem Basissubstrat (101);
mindestens eine Ausnehmung (c) in den mehreren Pixeleinheiten (1); und
Pixelelektroden (2) in den mehreren Pixeleinheiten (1), die die mindestens eine Ausnehmung (c) bedecken;
wobei eine orthographische Projektion einer Öffnung jeder Ausnehmung (c) auf das Basissubstrat (101) eine orthographische Projektion eines Bodens der Ausnehmung (c) auf das Basissubstrat (101) bedeckt und eine Fläche der orthographischen Projektion der Öffnung der Ausnehmung (c) auf das Basissubstrat (101) größer ist als eine Fläche der orthographischen Projektion des Bodens der Ausnehmung (c) auf das Basissubstrat (101);
wobei das Arraysubstrat ferner aufweist: eine Reservierungsschicht (4) zwischen den Pixelelektroden (2) und dem Basissubstrat (101), und eine erste Isolationsschicht (51) zwischen der Reservierungsschicht (4) und den Pixelelektroden (2); und
die erste Isolationsschicht (51) mindestens ein erstes Durchkontaktierungsloch (53) in den mehreren Pixeleinheiten (1) aufweist;
wobei die Reservierungsschicht (4) mindestens ein zweites Durchkontaktierungsloch (41) aufweist, das jedem ersten Durchkontaktierungsloch (53) entspricht; und
eine orthographische Projektion jedes ersten Durchkontaktierungslochs (53) auf das Basissubstrat (101) und eine orthographische Projektion eines entsprechenden zweiten Durchkontaktierungslochs (41) auf das Basissubstrat (101) einen überlappenden Bereich aufweisen;
wobei das Arraysubstrat ferner aufweist: mehrere Datenleitungen (7); mehrere Gate-Leitungen (8); Dünnschichttransistoren in jeweiligen Pixeleinheiten (1); eine Gate-Isolationsschicht (52) zwischen den aktiven Schichten (6) der Dünnschichttransistoren und einer Schicht, an der sich Gates der Dünnschichttransistoren befinden; eine zweite Isolationsschicht (56) zwischen einer Schicht, an der sich Sources und Drains der Dünnschichttransistoren befinden, und aktiven Schichten (6) der Dünnschichttransistoren;
wobei die Gate-Isolationsschicht (52) mindestens ein drittes Durchkontaktierungsloch (54) aufweist, das jedem ersten Durchkontaktierungsloch (53) entspricht;
die orthographische Projektion jedes ersten Durchkontaktierungslochs (53) auf das Basissubstrat (101) und eine orthographische Projektion eines entsprechenden dritten Durchkontaktierungslochs (54) auf das Basissubstrat (101) einen überlappenden Bereich aufweisen; und
jede Ausnehmung (c) ein erstes Durchkontaktierungsloch (53) von dem mindestens einen ersten Durchkontaktierungsloch, ein entsprechendes zweites Durchkontaktierungsloch (41) von dem mindestens einen zweiten Durchkontaktierungsloch und ein entsprechendes drittes Durchkontaktierungsloch (54) von dem mindestens einen dritten Durchkontaktierungsloch aufweist
wobei die Reservierungsschicht (4) auf derselben Schicht angeordnet und aus demselben Material hergestellt ist wie die mehreren Datenleitungen (7); oder
die Reservierungsschicht (4) auf derselben Schicht angeordnet und aus demselben Material hergestellt ist wie die mehreren Gate-Leitungen (8); oder
die Reservierungsschicht (4) auf derselben Schicht angeordnet und aus demselben Material hergestellt ist wie die aktiven Schichten (6) der Dünnschichttransistoren; oder
die Reservierungsschicht (4) eine erste Sub-Reservierungsschicht (401) und eine zweite Sub-Reservierungsschicht (402) aufweist; wobei die erste Sub-Reservierungsschicht (401) auf derselben Schicht wie die Sources der Dünnschichttransistoren angeordnet ist und die zweite Sub-Reservierungsschicht (402) auf derselben Schicht wie die aktiven Schichten (6) der Dünnschichttransistoren angeordnet ist.

2. Arraysubstrat nach Anspruch 1, wobei ein Muster jedes ersten Durchkontaktierungslochs (53) eine Ellipse umfasst, ein Muster jedes zweiten Durchkontaktierungslochs (41) eine Ellipse umfasst; und eine orthographische Projektion einer Längsachse jedes zweiten Durchkontaktierungslochs (41) auf das Basissubstrat (101) sich mit einer orthographischen Projektion einer Längsachse eines entsprechenden ersten Durchkontaktierungslochs (53) auf das Basissubstrat (101) schneidet.

3. Arraysubstrat nach Anspruch 2, wobei ein Winkel zwischen der orthographischen Projektion der Längsachse jedes zweiten Durchkontaktierungslochs (41) auf das Basissubstrat (101) und der orthographischen Projektion der Längsachse des entsprechenden ersten Durchkontaktierungslochs (53) auf das Basissubstrat (101) größer als 0 Grad und kleiner als oder gleich 90 Grad ist.

4. Arraysubstrat nach Anspruch 1, wobei das Arraysubstrat ferner aufweist: eine Hilfsschicht (9) zwischen der Gate-Isolationsschicht (52) und dem Basissubstrat (101); wobei die Hilfsschicht (9) ein viertes Durchkontaktierungsloch (55) aufweist, das
jedem zweiten Durchkontaktierungsloch (41) entspricht; und eine orthographische Projektion jedes zweiten Durchkontaktierungslochs (41) auf das Basissubstrat (101) eine orthographische Projektion eines entsprechenden vierten Durchkontaktierungslochs (55) auf das Basissubstrat (101) bedeckt und größer ist als diese; und
jede Ausnehmung (c) ein erstes Durchkontaktierungsloch (53), ein entsprechendes zweites Durchkontaktierungsloch (41) und ein entsprechendes viertes Durchkontaktierungsloch (55) aufweist.

5. Arraysubstrat nach Anspruch 4, wobei jedes vierte Durchkontaktierungsloch (55) ein sich verjüngendes Loch aufweist; und ein Winkel zwischen einer geneigten Fläche des sich verjüngenden Lochs und einer oberen Fläche des Basissubstrats (101) größer als oder gleich 15 Grad und kleiner als oder gleich 75 Grad ist.

6. Arraysubstrat nach Anspruch 4, wobei das Arraysubstrat ferner mehrere Gate-Leitungen (8) aufweist; und
die Hilfsschicht (9) sich auf derselben Schicht wie die mehreren Gate-Leitungen (8) befindet und von diesen isoliert angeordnet ist;
wobei das Arraysubstrat ferner eine gemeinsame Elektrode (3) aufweist, die auf derselben Schicht wie die mehreren Gate-Leitungen (8) angeordnet ist.

7. Arraysubstrat nach Anspruch 1, wobei eine orthographische Projektion einer Längsachse eines zweiten Durchkontaktierungslochs (41a), das auf der ersten Sub-Reservierungsschicht (401) auf dem Basissubstrat (101) angeordnet ist, sich mit einer orthographischen Projektion einer Längsachse eines entsprechenden zweiten Durchkontaktierungslochs (41b) schneidet, das auf der zweiten Sub-Reservierungsschicht (402) auf dem Basissubstrat (101) angeordnet ist; wobei das zweite Durchkontaktierungsloch (41a), das auf der ersten Sub-Reservierungsschicht (401) angeordnet ist, und das entsprechende zweite Durchkontaktierungsloch (41b), das auf der zweiten Sub-Reservierungsschicht (402) angeordnet ist, eine elliptische Gestalt aufweisen.

8. Arraysubstrat nach Anspruch 7, wobei eine orthographische Projektion eines Zentrums des zweiten Durchkontaktierungslochs (41a), das auf der ersten Sub-Reservierungsschicht (401) angeordnet ist, auf das Basissubstrat (101) mit einer orthographischen Projektion eines Zentrums des entsprechenden zweiten Durchkontaktierungslochs (41b), das auf der zweiten Sub-Reservierungsschicht (402) angeordnet ist, auf das Basissubstrat (101) überlappt; und
wobei ein Winkel zwischen der orthographischen Projektion der Längsachse des zweiten Durchkontaktierungslochs (41a), das auf der ersten Sub-Reservierungsschicht (401) auf dem Basissubstrat (101) angeordnet ist, und der orthographischen Projektion der Längsachse des entsprechenden zweiten Durchkontaktierungslochs (41b), das auf der zweiten Sub-Reservierungsschicht (402) auf dem Basissubstrat (101) angeordnet ist, größer als 0 Grad und kleiner als oder gleich 90 Grad ist.

9. Flüssigkristalltafel, das Arraysubstrat nach einem der Ansprüche 1 bis 8 aufweisend.

10. Anzeigevorrichtung, die Flüssigkristalltafel nach Anspruch 9 aufweisend.

## Revendications

1. Un substrat matriciel, comprenant :
un substrat de base (101) ;
une pluralité d'unités de pixel (1) sur le substrat de base (101) ;
au moins un évidement (c) dans la pluralité d'unités de pixel (1) ; et
des électrodes de pixel (2) dans la pluralité d'unités de pixel (1) et recouvrant ledit au moins un évidement (c) ;
une projection orthographique d'une ouverture de chaque évidement (c) sur le substrat de base (101) couvrant une projection orthographique d'un fond de l'évidement (c) sur le substrat de base (101), et une zone de la projection orthographique de l'ouverture de l'évidement (c) sur le substrat de base (101) est supérieure à une zone de la projection orthographique du fond de l'évidement (c) sur le substrat de base (101) ;
le substrat matriciel comprenant en outre :
une couche de réservation (4) entre les électrodes de pixel (2) et le substrat de base (101), et une première couche d'isolation (51) entre la couche de réservation (4) et les électrodes de pixel (2) ; et
la première couche d'isolation (51) comprend au moins un premier trou formant via (53) dans la pluralité d'unités de pixel (1) ;
la couche de réservation (4) comprenant au moins un deuxième trou formant via (41) correspondant à chaque premier trou formant via (53) ; et
une projection orthographique de chaque premier trou formant via (53) sur le substrat de base (101), et une projection orthographique d'un deuxième trou formant via correspondant (41) sur le substrat de base (101) ont une zone de chevauchement ;
le substrat matriciel comprenant en outre : une pluralité de lignes de données (7) ;
une pluralité de lignes de grille (8) ; des transistors à couches minces dans des unités de pixel respectives (1) ; une couche (52) d'isolation de grille entre les couches actives (6) des transistors à couches minces, et une couche au niveau de laquelle sont situées les grilles des transistors à couches minces ; une deuxième couche d'isolation (56) entre une couche dans laquelle sont situés les sources et les drains des transistors à couches minces et des couches actives (6) des transistors à couches minces ;
la couche (52) d'isolation de grille comprenant au moins un troisième trou formant via (54) correspondant à chaque premier trou formant via (53) ;
la projection orthographique de chaque premier trou formant via (53) sur le substrat de base (101), et une projection orthographique d'un troisième trou formant via correspondant (54) sur le substrat de base (101) ont une zone de chevauchement ; et
chaque évidement (c) comprend un premier trou formant via (53) provenant dudit au moins un premier trou via, un deuxième trou formant via correspondant (41) provenant dudit au moins un deuxième trou formant via et un troisième trou formant via correspondant (54) provenant dudit au moins un troisième trou formant via ;
la couche de réservation (4) étant agencée au niveau d'une même couche et étant constituée du même matériau que la pluralité de lignes de données (7) ; ou
la couche de réservation (4) étant agencée au niveau d'une même couche et étant constituée du même matériau que la pluralité de lignes de grille (8) ; ou
la couche de réservation (4) étant agencée sur une même couche et étant constituée du même matériau que les couches actives (6) des transistors à couches minces ; ou
la couche de réservation (4) comprenant une première sous-couche de réservation (401) et une deuxième sous-couche de réservation (402) ; la première sous-couche de réservation (401) étant agencée au niveau d'une même couche que les sources des transistors à couches minces, et la deuxième sous-couche de réservation (402) étant agencée au niveau d'une même couche que les couches actives (6) des transistors à couches minces.

2. Le substrat matriciel selon la revendication 1, dans lequel une conformation de chaque premier trou formant via (53) comprend une ellipse, une conformation de chaque deuxième trou formant via (41) comprend une ellipse ; et une projection orthographique d'un grand axe de chaque deuxième trou formant via (41) sur le substrat de base (101) est en intersection avec une projection orthographique d'un grand axe d'un premier trou formant via correspondant (53) sur le substrat de base (101).

3. Le substrat matriciel selon la revendication 2, dans lequel un angle entre la projection orthographique du grand axe de chaque deuxième trou formant via (41) sur le substrat de base (101), et la projection orthographique du grand axe du premier trou formant via correspondant (53) sur le substrat de base (101) est supérieur à 0 degré et inférieur ou égal à 90 degrés.

4. Le substrat matriciel selon la revendication 1, dans lequel le substrat matriciel comprend en outre : une couche auxiliaire (9) entre la couche (52) d'isolation de grille et le substrat de base (101) ; la couche auxiliaire (9) comprend un quatrième trou formant via (55) correspondant à chaque deuxième trou formant via (41) ; et une projection orthographique de chaque deuxième trou formant via (41) sur le substrat de base (101) recouvre une projection orthographique d'un quatrième trou formant via correspondant (55) sur le substrat de base (101) et est plus grande que cette projection ; et
chaque évidement (c) comprend un premier trou formant via (53), un deuxième trou formant via correspondant (41) et un quatrième trou formant via correspondant (55).

5. Le substrat matriciel selon la revendication 4, dans lequel chaque quatrième trou formant via (55) comprend un trou conique ; et un angle entre une surface inclinée du trou conique et une surface supérieure du substrat de base (101) est supérieur ou égal à 15 degrés et inférieur ou égal à 75 degrés.

6. Le substrat matriciel selon la revendication 4, le substrat matriciel comprenant en outre une pluralité de lignes de grille (8) ; et
la couche auxiliaire (9) est située au niveau d'une même couche que la pluralité de lignes de grille (8) et agencée de manière isolée par rapport à celle-ci ;
le substrat matriciel comprenant en outre une électrode commune (3) agencée au niveau d'une même couche que la pluralité de lignes de grille (8).

7. Le substrat matriciel selon la revendication 1, dans lequel une projection orthographique d'un grand axe d'un deuxième trou formant via (41a) agencé sur la première sous-couche de réservation (401) sur le substrat de base (101) est en intersection avec une projection orthographique d'un grand axe d'un deuxième trou formant via correspondant (41b) agencé sur la deuxième sous-couche de réservation (402) sur le substrat de base (101) ; le deuxième trou formant via (41a) agencé sur la première sous-couche de réservation (401) et le deuxième trou formant via correspondant (41b) agencé sur la deuxième sous-couche de réservation (402) ont une forme elliptique.

8. Le substrat matriciel selon la revendication 7, dans lequel une projection orthographique d'un centre du deuxième trou formant via (41a) agencé sur la première sous-couche de réservation (401) sur le substrat de base (101) chevauche une projection orthographique d'un centre du deuxième trou formant via correspondant (41b) agencé sur la deuxième sous-couche de réservation (402) sur le substrat de base (101) ; et
un angle entre la projection orthographique du grand axe du deuxième trou formant via (41a) agencé sur la première couche de sous-réservation (401) sur le substrat de base (101), et la projection orthographique du grand axe du deuxième trou formant via correspondant (41b) agencé sur la deuxième couche de sous-réservation (402) sur le substrat de base (101) est supérieur à 0 degré et inférieur ou égal à 90 degrés.

9. Un panneau d'affichage à cristaux liquides, comprenant le substrat matriciel selon l'une quelconque des revendications 1 à 8.

10. Un dispositif d'affichage, comprenant le panneau d'affichage à cristaux liquides selon la revendication 9.
